# EUROPEAN PATENT SPECIFICATION

(11) **EP 4 038 397 B1**
(45) Date of publication and mention of the grant of the patent: **27.08.2025**
(21) Application number: 19947873.6
(22) Date of filing: 19.11.2019
(51) Int. Cl.: G01R 19/252, G01R 19/00, G01R 35/00

(54) **A MEASUREMENT APPARATUS AND A METHOD FOR CORRECTING MEASURES THEREFROM**
MESSVORRICHTUNG UND VERFAHREN ZUR KORREKTUR VON MESSUNGEN DARAUS
APPAREIL DE MESURE ET PROCÉDÉ DE CORRECTION DES MESURES EN PROVENANT

(30) Priority: 03.10.2019 IN 201921040041
(43) Date of publication of application: 10.08.2022
(73) Proprietor: Selec Controls Private Limited, Navi Mumbai, 400710 MAH (IN)
(72) Inventor: KAJI, Samir, Mumbai 400710 (IN)
(74) Representative: FRKelly
(86) International application number: PCT/IN2019/050854
(87) International publication number: WO 2021/064738

(56) References cited:
- WO-A2-2012/003492
- GB-A- 2 552 948
- US-A1- 2013 128 396
- US-A1- 2015 002 137
- US-A1- 2019 072 633
- GERRARD P W: "STRETCHING OUT CALIBRATION INTERVALS", TEST AND MEASUREMENT WORLD, REED BUSINESS INFORMATION, HIGHLANDS RANCH, CO, US, vol. 12, no. 6, 1 May 1992 (1992-05-01), pages 37 - 38, XP000306647, ISSN: 0744-1657

## Description

### FIELD OF INVENTION

The present invention relates to measurement, particularly the measurement of analog parameters, and more particularly to a measurement apparatus and method therefor.

### BACKGROUND

Present invention is being disclosed with the art and science of current measurement; however it is applicable equally effectively to apparatus and method of measurement of speed of a car or quantity of mayonnaise sauce in a sandwich, and every other effect based measurement.

Measurement of parameters is a known important step in any activity sensitive to quality of output. Use of an effectbased transducer is known for safe and effective measurement. Example - We measure temperature by measuring expansion of mercury or any other suitable liquid.

Such measurement has essentially a measuring sensor and an output device imparting measurement value.

Every effect based measuring sensor has errors in sensing the parameter. The error may be due to the sensor construction, and or due to environment and or due to aging. The same is also true for the output device.

It is also known that such error is different for same design and manufacturing process of measuring sensor as well as output device, primarily due to manufacturing variations. Illustratively, a conventional current transformer which senses primary current by its magnetic effect and then reproduces a secondary current has some error introduced at each stage including but not limited to wire manufacture, winding of wire, placement of wire on a core, generation of magnetic field and then secondary current, and so on.

It is known that an error data, which is essentially a tabulation of factor of error at discrete values of measurement and which is also known as a calibration chart, is generatable, to know the error introduced due to any reason. Document GB2552948 discloses a method for obtaining set of calibration points from a sample data set for performing calibration on measurement devices involving adding a sample point corresponding to the largest error to a list of calibration points based on largest error.

When measuring sensor and measuring devices are connected to each other to form a measuring apparatus or measuring system, in which any measuring sensor is connected to any measuring device, the cumulative or system error is Sensor device error + measuring device error. In such cases, the measurement inaccuracies of the sensor are not possible to compensate. So if higher accuracy is required, the individual accuracies of the sensor as well as the measuring device each have to be high. Calibrating the sensor independently and pairing it at the time of connection to the measuring device allows the sensor inaccuracy to be eliminated. This could have been achieved in the normal course only if a specific unit of sensor and a specific unit of measuring device are considered together as a pair or if the two were integrated as a measuring system and calibrated for the final measurement with error elimination techniques. This concept significantly limits industrial flexibility and inflates cost.

Present invention effectively addresses this industrial need and gap.

### OBJECTIVES

The objective is to invent an instrument that gives an accurate measurement of a desired parameter.

Another objective is to invent an instrument that gives an accurate measurement over a wide range of desired parameter.

Yet another objective is to invent an instrument that is usable for measurement of different parameters.

Yet another objective is to invent an instrument that effectively utilizes calibration information of the measurement sensor deployed.

Yet another objective is to invent an instrument whose constituents are calibrated independently.

Yet another objective is to invent an instrument whose sensor is changeable and the instrument does not need cumulative calibration.

### SUMMARY OF INVENTION

The present invention is a measuring apparatus comprising a measurement sensor and a computational device . The measurement sensor comprises a measurement means , a protected read-write-erase memory having a plurality of calibration tabulation including a plurality of primary calibration tabulation and or a plurality of secondary calibration tabulation and or a plurality of degenerative calibration tabulation along with an application address , and a commensurate electric powering means .

A calibration tabulation is a set of discrete data giving a real value of a function and correspondingly a virtual value of the function of the sensor. The virtual value includes a measured value, a predicted value and or a projected value. The calibration tabulation is generated for each and every individual measurement means in a controlled condition and independent of the computational device with the measurement means which is subsequently to be paired. A primary calibration tabulation is a set of discrete data giving a real value of a primary function and correspondingly a measured value of the primary function of the sensor. A secondary calibration tabulation is a set of discrete data giving a real value of a support function and correspondingly a measured value of the secondary function of the sensor.

A measurement means includes one or more primary measurement means and one or more secondary measurement means. A degenerative calibration tabulation is a set of discrete data giving a value of a degenerative function and correspondingly a predicted value of the primary function of the sensor. The predictive value of the primary function is algorithm, statistical or knowledge based. The application address of the measurement sensor is a set of level one and level two permanent details of the measurement sensor . For the current measurement sensor, the level one permanent detail is a current measurement transformation ratio like 200/5 which means a current transformer of 200 Amp primary rating and 5 Amp secondary rating, a permissible temperature value. The level two permanent details is a serial number identifying a source and period of production. The computation device comprises, a data receiver , a correction calculator , an input output unit including a configurator , and a commensurate electric powering means. The data receiver receives an application address, a measurement value and a selected calibration data from the measurement sensor.

The configurator is configured by the user for setting up names and measuring units of primary functions, names and measuring units of secondary functions, names and measuring units of degenerative functions. The configurator is also configured by user for algebraic expression or Boolean expression for data pertaining to each function. Persons skilled in the art are well aware of such behavior of different samples of same measurement sensors, and which is unavoidable due to manufacturing variations from sample to sample. The present invention corrects this anomaly effectively, by pairing any measurement sensor with any computation device . The measurement apparatus has the measurement sensor electrically connected for power and or control as well as data communication with the computation device wherein the functions are configured. The electrical connection is a hard wired or a radio connection or a combination thereof. Techniques for such connection are well known and changing rapidly and are not elaborated here to ensure clarity on inventive details. When the measurement apparatus is activated, the computation device seeks and receives the application address from the measurement sensor . In the illustrative case where the measurement sensor is a current measurement sensor, the computational device receives at least a transformation ratio. The computation device seeks and receives a measured value Y_{MP} of a primary function. This measured value Y_{MP} is a virtual value. The computation device next seeks a next lower real value and corresponding virtual value (X_{LP}, Y_{LS}) , and a next higher real value and corresponding higher virtual value (X_{HP}, Y_{HP}) from the primary calibration tabulation . From these two values and the computation device calculates a linear or a non-linear contour of a calibration segment and computes a real value X_{MP}. Illustratively, the linear contour is calculated by deploying a known mathematical expression like Y=mX+c where m is a slope of the contour and c is a constant and these could be easily calculated by solving two algebraic equations. The non-linear contour is likewise calculated by using two or more values from the graph. Selection of which expression to be used is based on application of the measurement apparatus as per present invention.

Likewise, the computational device seeks and receives a measured value Y_{MS} of a secondary function. This measured value Y_{MS} is a virtual value. The computational device next seeks a next lower real value and corresponding virtual value (X_{LS}, Y_{LS}) , and a next higher real value and corresponding higher virtual value (X_{HS}, Y_{HS}) from the secondary calibration tabulation . From these two points, the computational device calculates a linear or a non-linear contour of a calibration segment and computes a real value X_{MS}.

Next the computation device determines a degenerative function with reference to a real time ageing and computes a predicted value of the primary function. The computation device computes a corrected value of the primary function by taking into computation all the real values of the primary function the secondary function and the degenerative function.

As a variation, when a measurement sensor connected to a computation device returns no data, the computation device considers a default value, generally a numeric ONE. In other words, a measurement sensor which is merely a conventional sensor with no memory is usable with computation device as well.

### BRIEF DESCRIPTION OF DRAWINGS

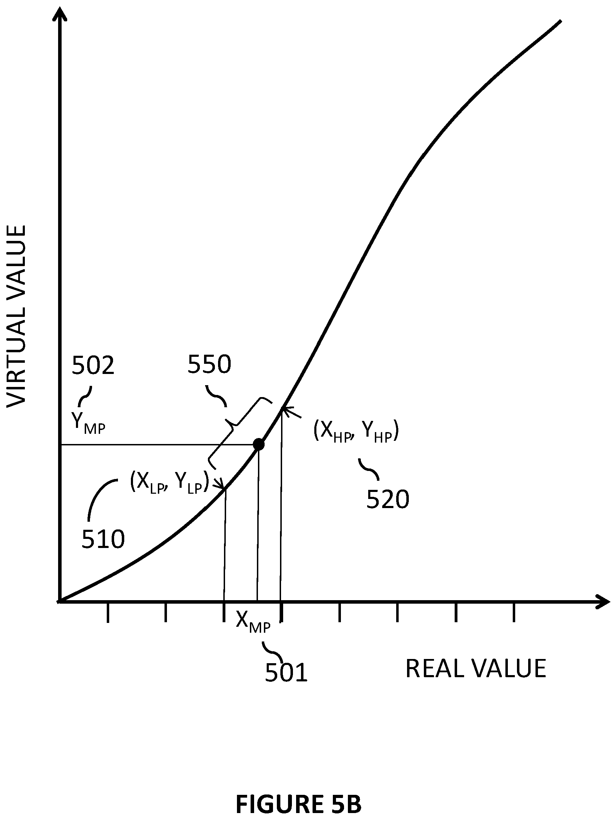

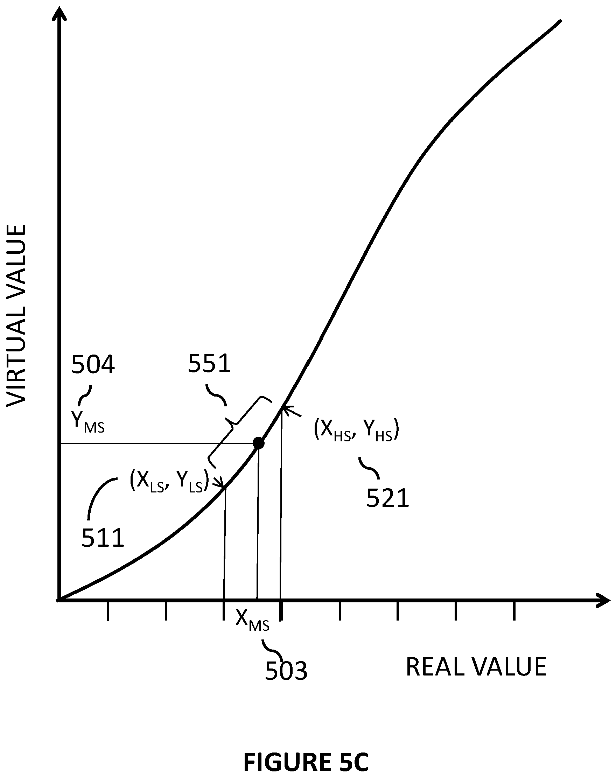

Figure-1 is a block diagram of an apparatus as per present invention.
Figure-2 is a block diagram of a measurement sensor as per present invention. Figure-3A to 3D are illustrative calibration tables of different measurement parameters.
Figure-4 is a block diagram of a computation device as per present invention.
Figure-5A is a graphical representation of different calibration curves, while Figure 5B, 5C is a graphical representation of a set of calibration points used for measurement correction.
Figure-6A, 6B and 6C is a graphical representation of an illustrative set of real and virtual values for arriving at a corrected measure.

### DETAILED DESCRIPTION OF DRAWINGS

Present invention is described with the help of accompanying drawings. The invention has a wide application, and the explanation and illustrations should not be construed to limit the invention.

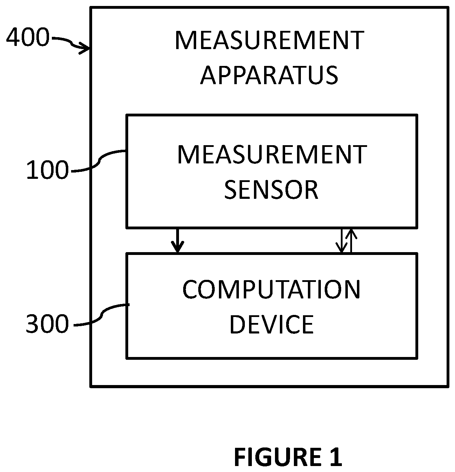

Figure 1, the present invention is a measuring apparatus **400** comprising a measurement sensor **100** and a computational device **300.**

To facilitate easy and unambiguous understanding of the invention, the drawings and description illustrated for an electric current measurement sensor and an electric current computational device.

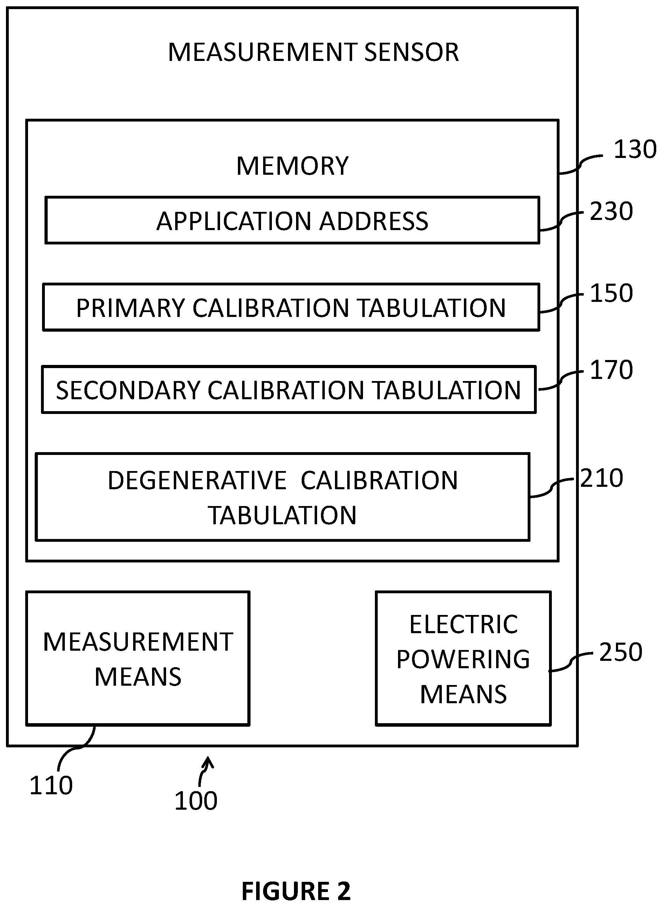

Figure 2, the measurement sensor **100** comprises a measurement means **110,** a protected read-write-erase memory **130** having a plurality of calibration tabulation including a plurality of primary calibration tabulation **150** and or a plurality of secondary calibration tabulation **170** and or a plurality of degenerative calibration tabulation **210** along with an application address **230,** and a commensurate electric powering means **250.**

A calibration tabulation is a set of discrete data giving a real value **410** of a function and correspondingly a virtual value **420** of the function of the sensor. The virtual value **420** includes a measured value, a predicted value and or a projected value. The calibration tabulation **150, 170 and 210** is pre-generated for each and every individual measurement means in a controlled condition and independent of the computational device **300** with which the measurement means **110** is subsequently to be paired. Illustratively, for an ac current measurement sensor, a tabulation of ratio error is generated by passing a known value of ac current from primary winding of current transformer and capturing the value of ac current as reported by the secondary winding of the current transformer. Here, the known value corresponds to the real value of the function and the reported value corresponds to the virtual value of the function.

A primary calibration tabulation **150** is a set of discrete data giving a real value **410** of a primary function and correspondingly a measured value of the primary function of the sensor.

Correspondingly, an ac current measurement sensor is a conventional current transformer with a primary winding and a secondary winding. Many a time, the primary winding is merely a single conductor passing through a window of a ferromagnetic core. Such a single conductor constitutes ONE turn of the primary winding while a relatively large number of turns are provided on the ferromagnetic core. A dc current measurement sensor may comprise a Hall Sensor.

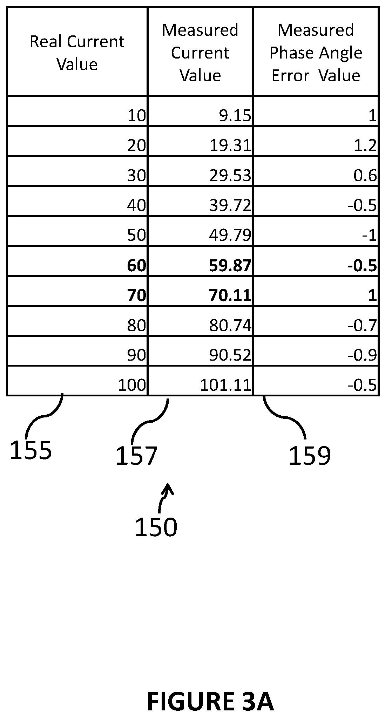

For a current measurement sensor, the primary calibration tabulation **150** is generally a set of discrete real current value **155,** a corresponding measured current value **157** and a corresponding measured phase angle error value **159,** Figure 3A.

A secondary calibration tabulation **170** is a set of discrete data giving a real value of a support function and correspondingly a measured value of the secondary function of the sensor.

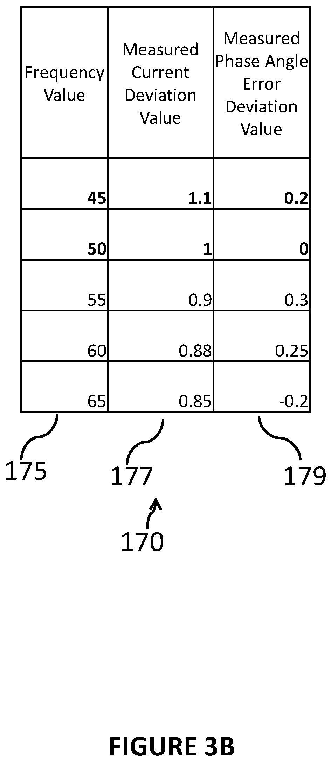

For the current measurement sensor, the secondary calibration tabulation **170** is generally a set of discrete frequency value **175,** a corresponding measured current deviation value **177** and a corresponding measure phase angle error deviation value **179,** Figure 3B.

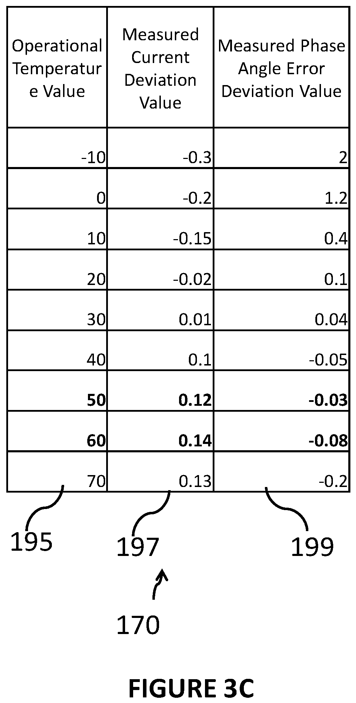

Also, for the current measurement sensor, the secondary calibration tabulation **170** is generally a set of discrete operational temperature value **195,** a corresponding measured current deviation value **197** and a corresponding measure phase angle error deviation value **199,** Figure 3C.

Consequently, a measurement means **110** includes one or more primary measurement means and one or more secondary measurement means. For a current measurement apparatus, the primary measurement means is a primary and a secondary winding wound on a ferromagnetic core, while the secondary means is but not limited to a frequency measurement, a temperature measurement, a humidity measurement, a vibration measurement.

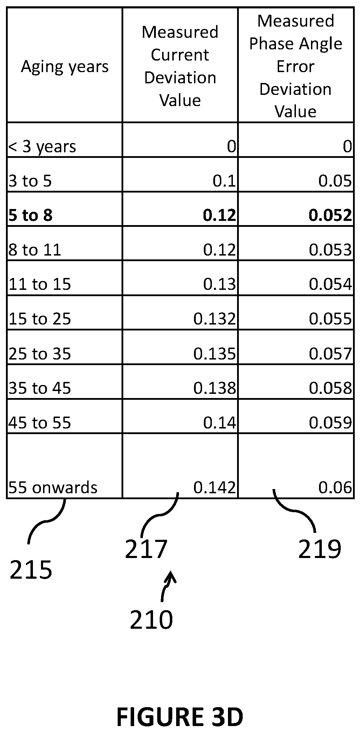

A degenerative calibration tabulation **210** is a set of discrete data giving a value of a degenerative function and correspondingly a predicted value of the primary function of the sensor. The degenerative function is a measure of time and or use of the current measurement sensor which necessitates a re-calibration of the current measurement sensor. Figure 3D. The predictive value of the primary function is algorithm, statistical or knowledge based.

For the current measurement sensor, the degenerative calibration tabulation **210** is a set of time period **215** in months or years as per industry guidelines, and a corresponding predicted current deviation value **217** and a corresponding predicted phase angle error deviation value **219,** Figure 3D.

The application address **230** of the measurement sensor **100** is a set of level one and level two permanent details of the measurement sensor **100.** For the current measurement sensor **100,** the level one permanent detail is a current measurement transformation ratio like 200/5 which means a current transformer of **200** Amp primary rating and 5 Amp secondary rating, a permissible temperature value. The level two permanent details is a serial number identifying a source and period of production.

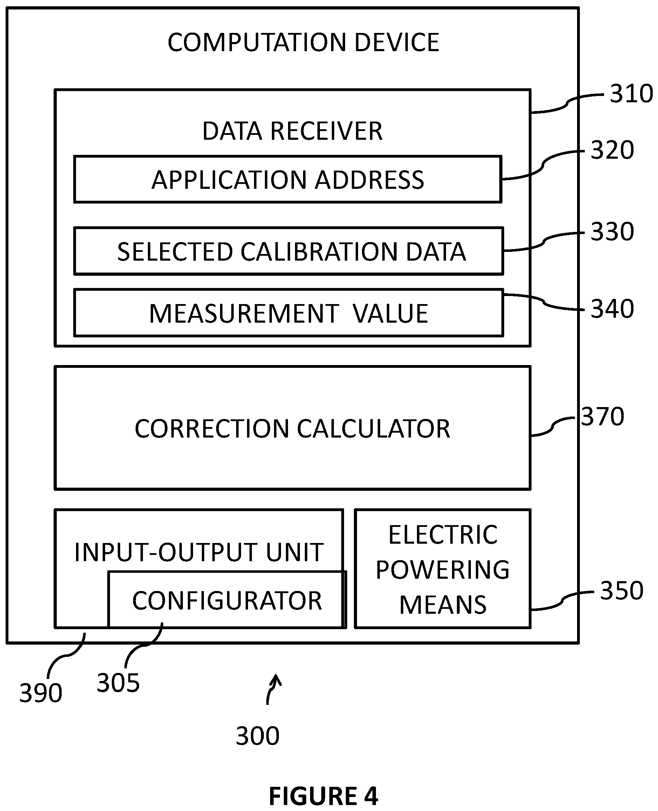

Figure 4, the computation device **300** comprises, a data receiver **310,** a correction calculator **370,** an input output unit **390** including a configurator **305,** and a commensurate electric powering means **350.**

The data receiver **310** receives an application address **230,** a measurement value **330** and a selected calibration data **340** from the measurement sensor **100.**

The configurator **305** is configured by the user for setting up names and measuring units of primary functions, names and measuring units of secondary functions, names and measuring units of degenerative functions.

### Example:

| Name | Measuring Units |
|---|---|
| Electric current | Ampere |
| Electric voltage | Volts |
| Temperature | °Centigrade |
| Use | Month |

The configurator **305** is also configured by user for algebraic expression or Boolean expression for data pertaining to each function. Example - data of some function is to be used as a multiplier as it is, while for another function the data may need to be added to or subtracted from a constant, which is generally numeric ONE, or it may be an additive or subtractive function instead of a multiplier.

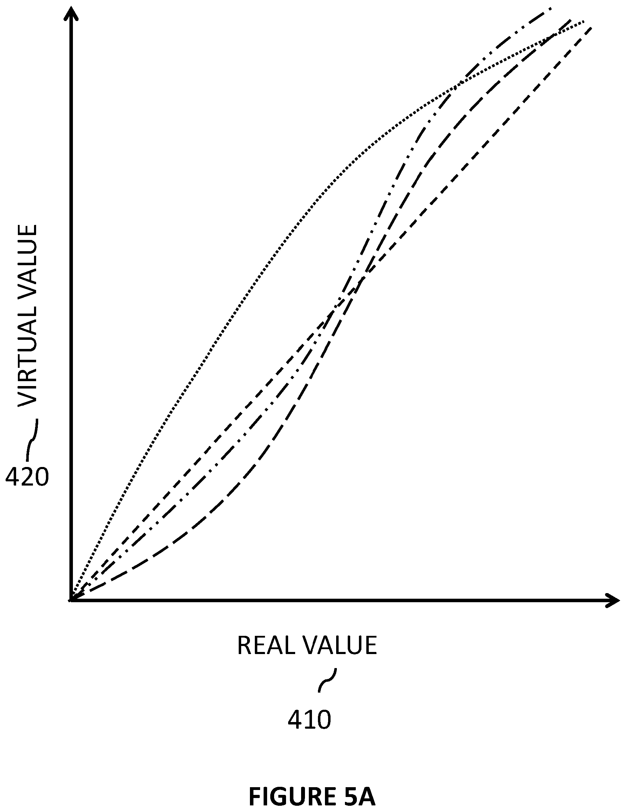

Figure 5A graphically shows a relation between the real value **410** of a function and correspondingly the virtual values **420** of the function of different measurement sensors. Virtual values are also different for different samples of same type of measurement sensor for same real value. Persons skilled in the art are well aware of such behavior of different samples of same measurement sensors, and which is unavoidable due to manufacturing variations from sample to sample. The present invention corrects this anomaly effectively, by pairing the measurement sensor **100** with the computation device **300.**

The measurement apparatus **400** has the measurement sensor **100** electrically connected for power and or control as well as data communication with the computation device **300** wherein the functions are configured. The electrical connection is a hard wired or a radio connection or a combination thereof. Techniques for such connection are well known and changing rapidly and are not elaborated here to ensure clarity on inventive details.

When the measurement apparatus **400** is activated, the computation device **300** seeks and receives the application address **230** from the measurement sensor **100.** In the illustrative case where the measurement sensor **100** is a current measurement sensor, the computational device **300** receives at least a transformation ratio.

Figure 5B, the computation device **300** seeks and receives a measured value Y_{MP} **502** of a primary function. This measured value Y_{MP} **502** is a virtual value. The computation device **300** next seeks a next lower real value and corresponding virtual value (X_{LP}, Y_{LS}) **510,** and a next higher real value and corresponding higher virtual value (X_{HP}, Y_{HP}) **520** from the primary calibration tabulation **150.** From these two values **510** and **520,** the computation device calculates a linear or a non-linear contour of a calibration segment **550** and computes a real value X_{MP} **501.**

Illustratively, the linear contour is calculated by deploying a known mathematical expression like Y=mX+c where m is a slope of the contour and c is a constant and these could be easily calculated by solving two algebraic equations.

The non-linear contour is likewise calculated by using two or more values from the graph. Selection of which expression to be used is based on application of the measurement apparatus as per present invention.

Likewise, Figure 5C, the computational device seeks and receives a measured value Y_{MS} **504** of a secondary function. This measured value Y_{MS} **504** is a virtual value. The computational device **300** next seeks a next lower real value and corresponding virtual value (X_{LS}, Y_{LS}) **511,** and a next higher real value and corresponding higher virtual value (X_{HS}, Y_{HS}) **521** from the secondary calibration tabulation **170.** From these two points, the computational device calculates a linear or a non-linear contour of a calibration segment **551** and computes a real value X_{MS} **503**.

Next the computation device **300** determines a degenerative function with reference to a real time ageing and computes a predicted value of the primary function.

The computation device **300** computes a corrected value of the primary function by taking into computation all the real values of the primary function the secondary function and the degenerative function.

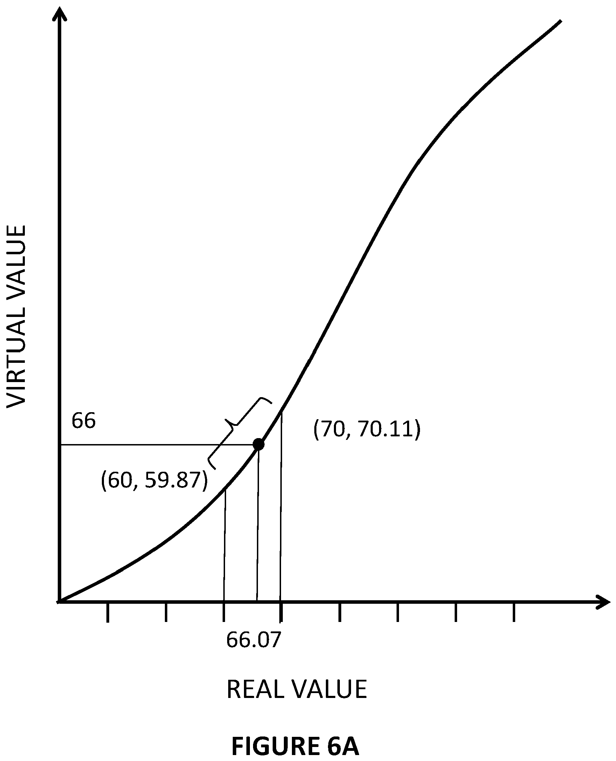

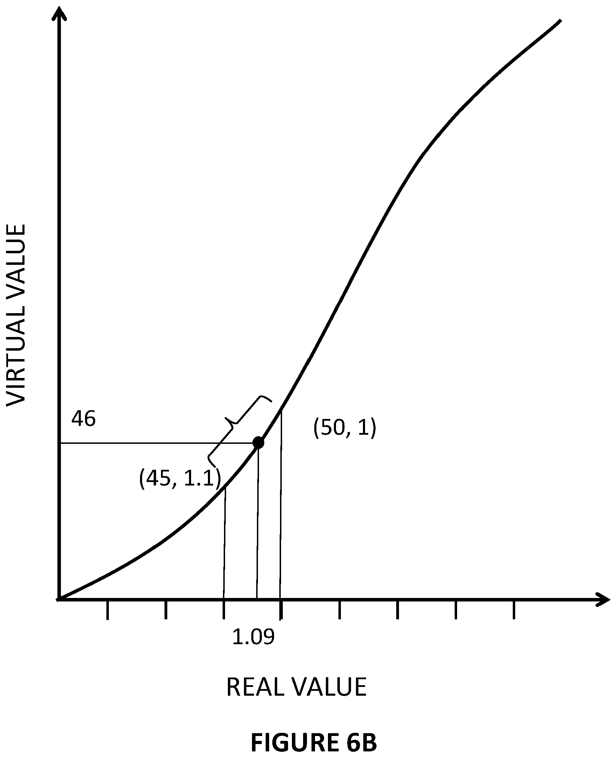

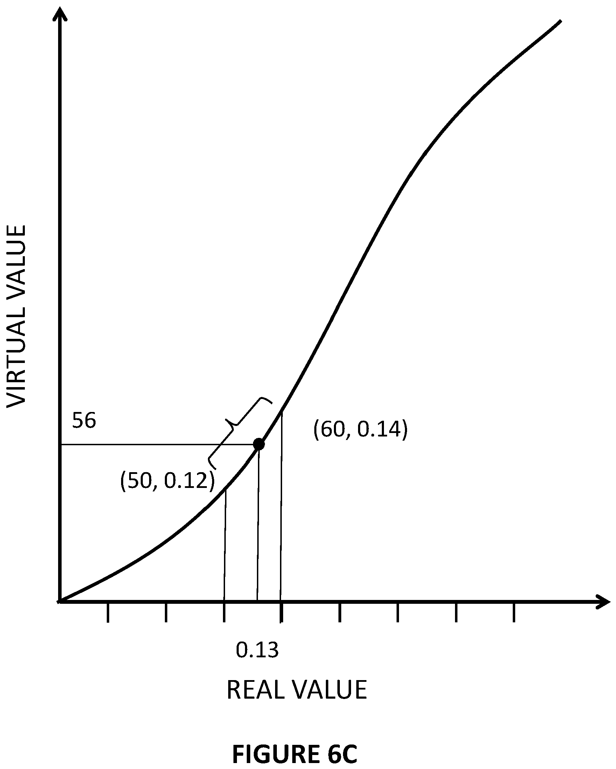

Example: For a 4 year old current measurement sensor that measures 66 ampere at a measured frequency of 46 Hz and at a measured temperature of 56°C, a corrected value of the primary function of current computed, in accordance with Figure 6A, 6B, 6C and 3D respectively, would be
= 66.07 x 1.09 x (1+1.13) x (1+0.1) ampere

As a variation, when a measurement sensor **100** connected to a computation device **300** returns no data, the computation device **300** considers a default value, generally a numeric ONE. On other words, a measurement sensor **100** which is merely a conventional sensor with no memory is usable with computation device **300** as well.

The essence of the invention is that the sensor and the device do not need to be calibrated together in factory or at site and thus the measurement sensor **100** and or the computational device **300** with compatible application address **230** are replaceable and or upgradable at a later date. Equally importantly, an economical sensor is usable and the apparatus as per present invention provides a precise output due to inventive method.

## Claims

1. A measuring apparatus 400 comprising a measurement sensor 100 and a computational device 300, each having respective commensurate electric powering means 250 and 350, the measurement apparatus 400 having an electrical connection for power and control as well as data communication with the computation device 300, **characterized in that**;
the measurement sensor 100 comprises a measurement means 110, a protected read-write-erase memory 130 having a plurality of calibration tabulation including a plurality of primary calibration tabulation 150 and a plurality of secondary calibration tabulation 170 and a plurality of degenerative calibration tabulation 210 along with an application address 230; and
the computation device 300 comprises a data receiver 310, a correction calculator 370, an input output unit 390 including a configurator 305;
wherein,
the calibration tabulation 150, 170 and 210 is pre-generated in a controlled condition and independent of the computational device 300 with which the measurement means 110 is subsequently to be paired;
the measurement means 110 includes one or more primary measurement means and one or more secondary measurement means;
the primary calibration tabulation 150 is a set of discrete data giving a real value 410 of a primary function and correspondingly a measured value of the primary function of the sensor;
the secondary calibration tabulation 170 is a set of discrete data giving a real value of a support function and correspondingly a measured value of the secondary function of the sensor;
the degenerative calibration tabulation 210 is a set of discrete data giving a value of a degenerative function and correspondingly a predicted value of the primary function of the sensor, the degenerative function is a measure of time and or use of the current measurement sensor which necessitates a re-calibration of the current measurement sensor, the predictive value of the primary function is algorithm, statistical or knowledge based;
the data receiver 310 receives an application address 230 which is a permanent details of the measurement sensor 100, a measurement value 330 and a selected calibration data 340 from the measurement sensor 100;
the configurator 305 is configurable for setting up a names and a measuring units of primary functions, the names and the measuring units of secondary functions, the names and the measuring units of degenerative functions, and for algebraic expression and Boolean expression for data pertaining to each function.

2. The measuring apparatus 400 as claimed in claim 1, wherein the measurement sensor 100 is an electric current measurement sensor.

3. The measuring apparatus 400 as claimed in claim 1, wherein the primary calibration tabulation 150 is a set of discrete real current value 155, a corresponding measured current value 157 and a corresponding measured phase angle error value 159.

4. The measuring apparatus 400 as claimed in claim 1, wherein the secondary calibration tabulation 170 is a set of discrete frequency value 175, a corresponding measured current deviation value 177 and a corresponding measure phase angle error deviation value 179.

5. The measuring apparatus 400 as claimed in claim 1, wherein the secondary calibration tabulation 170 is a set of discrete operational temperature value 195, a corresponding measured current deviation value 197 and a corresponding measure phase angle error deviation value 199.

6. The measuring apparatus 400 as claimed in claim 1, wherein the primary measurement means is a primary and a secondary winding wound on a ferromagnetic core, while the secondary means is any or all of a frequency measurement, a temperature measurement, a humidity measurement, a vibration measurement.

7. The measuring apparatus 400 as claimed in claim 1, wherein the degenerative calibration tabulation 210 is a set of time period 215 in months or years as per industry guidelines, and a corresponding predicted current deviation value 217 and a corresponding predicted phase angle error deviation value 219.

8. The measuring apparatus 400 as claimed in claim 1, wherein the application address 230 of the measurement sensor 100 is a set of level one and level two permanent details of the measurement sensor 100.

9. The measuring apparatus 400 as claimed in claim 1, wherein the electrical connection is a hard wired or a radio connection or a combination thereof.

10. A method of measuring a corrected value of one or more primary function by a measuring apparatus 400 comprising a measurement sensor 100 and a computation device 300, the method comprising the steps of:
i. Pairing the computation device 300 with the measurement sensor 100 by configuring an application address 230 and one or more primary functions, and one or more secondary functions and one or more degenerative function;
ii. Seeking and receiving by the computation device 300 a measured value YMP502 of the primary function;
iii. Seeking and receiving by the computation device 300 a next lower real value and corresponding virtual value (XLP, Y_{LS}) 510, and a next higher real value and corresponding higher virtual value (XHp, Y_{HP}) 520 from the primary calibration tabulation 150;
iv. Computing by the computation device 300 a linear or a non-linear contour of a calibration segment 550;
v. Computing by the computation device 300 a real value XMp 501;
vi. Seeking and receiving by the computational device 300 a measured value YMS 504 of a secondary function;
vii. Seeking and receiving by the computational device 300 a next lower real value and corresponding virtual value (XLs, Y_{LS}) 511, and a next higher real value and corresponding higher virtual value (XHS, 521 from the secondary calibration tabulation 170;
viii. Computing by the computational device 300 a linear or a non-linear contour of a calibration segment 551;
ix. Computing by the computation device 300 a real value XMS 503;
x. Determining by the computation device 300 a degenerative function with reference to a real time ageing;
xi. Selecting by the computing device 300 a predicted deviation value of the primary function;
xii. Computing by the computation device 300 a corrected value of the primary function by taking into computation all the real values of the primary function the secondary function and the degenerative function.

11. The method as claimed in claim 10, wherein the computation device 300 considers a default value on seeking and not receiving a virtual value 420.

12. The method as claimed in claim 10, wherein the measurement sensor 100 is any measurement sensor 100 with a compatible application address 230.

## Patentansprüche

1. Messvorrichtung 400, umfassend einen Messsensor 100 und eine Rechenvorrichtung 300, die jeweils eine jeweilige entsprechende elektrische Leistungsversorgungseinrichtung 250 und 350 aufweisen, wobei die Messvorrichtung 400 eine elektrische Verbindung für Leistung und Steuerung sowie Datenkommunikation mit der Rechenvorrichtung 300 aufweist, **dadurch gekennzeichnet, dass**:
der Messsensor 100 eine Messeinrichtung 110, einen geschützten Schreib-Lese-Lösch-Speicher 130, der eine Vielzahl von Kalibrierungstabellen aufweist, einschließlich einer Vielzahl von primären Kalibrierungstabellen 150 und einer Vielzahl von sekundären Kalibrierungstabellen 170 und einer Vielzahl von degenerativen Kalibrierungstabellen 210 zusammen mit einer Anwendungsadresse 230, umfasst; und
die Rechenvorrichtung 300 einen Datenempfänger 310, einen Korrekturberechner 370, eine Eingabe-Ausgabe-Einheit 390 einschließlich eines Konfigurators 305 umfasst;
wobei
die Kalibrierungstabelle 150, 170 und 210 unter kontrollierten Bedingungen und unabhängig von der Rechenvorrichtung 300, mit der die Messeinrichtung 110 anschließend zu koppeln ist, vorab generiert wird;
die Messeinrichtung 110 eine oder mehrere primäre Messeinrichtungen und eine oder mehrere sekundäre Messeinrichtungen beinhaltet;
die primäre Kalibrierungstabelle 150 ein Satz diskreter Daten ist, der einen realen Wert 410 einer primären Funktion und dementsprechend einen gemessenen Wert der primären Funktion des Sensors angibt;
die sekundäre Kalibrierungstabelle 170 ein Satz diskreter Daten ist, der einen realen Wert einer Unterstützungsfunktion und dementsprechend einen gemessenen Wert der sekundären Funktion des Sensors angibt;
die degenerative Kalibrierungstabelle 210 ein Satz diskreter Daten ist, der einen Wert einer degenerativen Funktion und dementsprechend einen vorhergesagten Wert der primären Funktion des Sensors angibt, wobei die degenerative Funktion ein Maß für die Zeit und/oder Verwendung des aktuellen Messsensors ist, das eine Neukalibrierung des aktuellen Messsensors erforderlich macht, wobei der Vorhersagewert der primären Funktion auf einem Algorithmus, einer Statistik oder Wissen basiert;
der Datenempfänger 310 eine Anwendungsadresse 230, die eine permanente Angabe des Messsensors 100 ist, einen Messwert 330 und ausgewählte Kalibrierungsdaten 340 von dem Messsensor 100 empfängt;
der Konfigurator 305 konfigurierbar ist, um Namen und Maßeinheiten von primären Funktionen, die Namen und Maßeinheiten von sekundären Funktionen, die Namen und Maßeinheiten von degenerativen Funktionen und für algebraische und boolesche Ausdrücke für die zu jeder Funktion gehörenden Daten festzulegen.

2. Messvorrichtung 400 nach Anspruch 1, wobei der Messsensor 100 ein Messsensor für elektrischen Strom ist.

3. Messvorrichtung 400 nach Anspruch 1, wobei die primäre Kalibrierungstabelle 150 ein Satz aus einem diskreten realen Stromwert 155, einem entsprechenden gemessenen Stromwert 157 und einem entsprechenden gemessenen Phasenwinkelfehlerwert 159 ist.

4. Messvorrichtung 400 nach Anspruch 1, wobei die sekundäre Kalibrierungstabelle 170 ein Satz aus einem diskreten Frequenzwert 175, einem entsprechenden gemessenen Stromabweichungswert 177 und einem entsprechenden gemessenen Phasenwinkelfehlerabweichungswert 179 ist.

5. Messvorrichtung 400 nach Anspruch 1, wobei die sekundäre Kalibrierungstabelle 170 ein Satz aus einem diskreten Betriebstemperaturwert 195, einem entsprechenden gemessenen Stromabweichungswert 197 und einem entsprechenden gemessenen Phasenwinkelfehlerabweichungswert 199 ist.

6. Messvorrichtung 400 nach Anspruch 1, wobei die primäre Messeinrichtung eine primäre und eine sekundäre Wicklung ist, die auf einen ferromagnetischen Kern gewickelt sind, während die sekundäre Einrichtung eine oder alle von einer Frequenzmessung, einer Temperaturmessung, einer Feuchtigkeitsmessung, einer Vibrationsmessung ist.

7. Messvorrichtung 400 nach Anspruch 1, wobei die degenerative Kalibrierungstabelle 210 ein Satz aus einem Zeitraum 215 in Monaten oder Jahren gemäß Industrierichtlinien und einem entsprechenden vorhergesagten Stromabweichungswert 217 und einem entsprechenden vorhergesagten Phasenwinkelfehlerabweichungswert 219 ist.

8. Messvorrichtung 400 nach Anspruch 1, wobei die Anwendungsadresse 230 des Messsensors 100 ein Satz von permanenten Einzelheiten der Ebene eins und der Ebene zwei des Messsensors 100 ist.

9. Messvorrichtung 400 nach Anspruch 1, wobei die elektrische Verbindung eine festverdrahtete oder eine Funkverbindung oder eine Kombination davon ist.

10. Verfahren zum Messen eines korrigierten Werts einer oder mehrerer primären Funktionen durch eine Messvorrichtung 400, die einen Messsensor 100 und eine Rechenvorrichtung 300 umfasst, wobei das Verfahren die folgenden Schritte umfasst:
i. Koppeln der Rechenvorrichtung 300 mit dem Messsensor 100 durch Konfigurieren einer Anwendungsadresse 230 und einer oder mehrerer primären Funktionen und einer oder mehrerer sekundären Funktionen und einer oder mehrerer degenerativen Funktionen;
ii. Suchen und Empfangen eines gemessenen Werts YMP502 der primären Funktion durch die Rechenvorrichtung 300;
iii. Suchen und Empfangen eines nächstniedrigeren realen Werts und eines entsprechenden virtuellen Werts (XLP, YLS) 510 und eines nächsthöheren realen Werts und eines entsprechenden höheren virtuellen Werts (XHp, YHP) 520 aus der primären Kalibrierungstabelle 150 durch die Rechenvorrichtung 300;
iv. Berechnen einer linearen oder nichtlinearen Kontur eines Kalibrierungssegments 550 durch die Rechenvorrichtung 300;
v. Berechnen eines realen Werts XMp 501 durch die Rechenvorrichtung 300;
vi. Suchen und Empfangen eines gemessenen Werts YMS 504 einer sekundären Funktion durch die Rechenvorrichtung 300;
vii. Suchen und Empfangen eines nächstniedrigeren realen Werts und eines entsprechenden virtuellen Werts (XLs, YLS) 511 und eines nächsthöheren realen Werts und eines entsprechenden höheren virtuellen Werts (XHS, YHS) 521 aus der sekundären Kalibrierungstabelle 170 durch die Rechenvorrichtung 300;
viii. Berechnen einer linearen oder nichtlinearen Kontur eines Kalibrierungssegments 551 durch die Rechenvorrichtung 300;
ix. Berechnen eines realen Werts XMS 503 durch die Rechenvorrichtung 300;
x. Bestimmen einer degenerativen Funktion in Bezug auf eine Echtzeitalterung durch die Rechenvorrichtung 300;
xi. Auswählen eines vorhergesagten Abweichungswerts der primären Funktion durch die Rechenvorrichtung 300;
xii. Berechnen eines korrigierten Werts der primären Funktion durch die Rechenvorrichtung 300, indem alle realen Werte der primären Funktion, der sekundären Funktion und der degenerativen Funktion in die Berechnung einbezogen werden.

11. Verfahren nach Anspruch 10, wobei die Rechenvorrichtung 300 einen Standardwert berücksichtigt, wenn sie einen virtuellen Wert 420 sucht und nicht empfängt.

12. Verfahren nach Anspruch 10, wobei der Messsensor 100 ein beliebiger Messsensor 100 mit einer kompatiblen Anwendungsadresse 230 ist.

## Revendications

1. Appareil de mesure 400 comprenant un capteur de mesure 100 et un dispositif de calcul 300, chacun ayant des moyens d'alimentation électrique respectifs proportionnés 250 et 350, l'appareil de mesure 400 ayant une connexion électrique pour l'alimentation et la commande ainsi que la communication de données avec le dispositif de calcul 300, **caractérisé en ce que** ;
le capteur de mesure 100 comprend un moyen de mesure 110, une mémoire protégée en lecture-écriture-effacement 130 ayant une pluralité de tabulations d'étalonnage comportant une pluralité de tabulations d'étalonnage primaires 150 et une pluralité de tabulations d'étalonnage secondaires 170 et une pluralité de tabulations d'étalonnage dégénératives 210, ainsi qu'une adresse d'application 230 ; et
le dispositif de calcul 300 comprend un - récepteur de données 310, un calculateur de correction 370, une unité d'entrée-sortie 390 comportant un configurateur 305 ;
dans lequel,
la tabulation d'étalonnage 150, 170 et 210 est pré-générée dans une condition commandée et indépendante du dispositif de calcul 300 avec lequel le moyen de mesure 110 doit ensuite être apparié ;
le moyen de mesure 110 comporte un ou plusieurs moyens de mesure primaires et un ou plusieurs moyens de mesure secondaires ;
la tabulation d'étalonnage primaire 150 est un ensemble de données discrètes donnant une valeur réelle 410 d'une fonction primaire et en conséquence une valeur mesurée de la fonction primaire du capteur ;
la tabulation d'étalonnage secondaire 170 est un ensemble de données discrètes donnant une valeur réelle d'une fonction de support et en conséquence une valeur mesurée de la fonction secondaire du capteur ;
la tabulation d'étalonnage dégénérative 210 est un ensemble de données discrètes donnant une valeur d'une fonction dégénérative et en conséquence une valeur prédite de la fonction primaire du capteur, la fonction dégénérative est une mesure du temps et/ou de l'utilisation du capteur de mesure de courant qui nécessite un réétalonnage du capteur de mesure de courant, la valeur prédictive de la fonction primaire est basée sur un algorithme, des statistiques ou des connaissances ;
le récepteur de données 310 reçoit une adresse d'application 230 qui est un détail permanent du capteur de mesure 100, une valeur de mesure 330 et des données d'étalonnage sélectionnées 340 du capteur de mesure 100 ;
le configurateur 305 est configurable pour configurer les noms et les unités de mesure de fonctions primaires, les noms et les unités de mesure de fonctions secondaires, les noms et les unités de mesure de fonctions dégénératives, et pour l'expression algébrique et l'expression booléenne de données relatives à chaque fonction.

2. Appareil de mesure 400 selon la revendication 1, dans lequel le capteur de mesure 100 est un capteur de mesure de courant électrique.

3. Appareil de mesure 400 selon la revendication 1, dans lequel la tabulation d'étalonnage primaire 150 est un ensemble de valeurs de courant réel discrètes 155, une valeur de courant mesuré correspondante 157 et une valeur d'erreur d'angle de phase mesurée correspondante 159.

4. Appareil de mesure 400 selon la revendication 1, dans lequel la tabulation d'étalonnage primaire 170 est un ensemble de valeurs de fréquence discrètes 175, une valeur d'écart de courant mesuré correspondante 177 et une valeur d'écart d'erreur d'angle de phase de mesure correspondante 179.

5. Appareil de mesure 400 selon la revendication 1, dans lequel la tabulation d'étalonnage secondaire 170 est un ensemble de valeurs de température opérationnelle discrètes 195, une valeur d'écart de courant mesuré correspondante 197 et une valeur d'écart d'erreur d'angle de phase de mesure correspondante 199.

6. Appareil de mesure 400 selon la revendication 1, dans lequel le moyen de mesure primaire est un enroulement primaire et un enroulement secondaire enroulés sur un noyau ferromagnétique, tandis que le moyen secondaire est l'un ou l'ensemble d'une mesure de fréquence, d'une mesure de température, d'une mesure d'humidité, d'une mesure de vibration.

7. Appareil de mesure 400 selon la revendication 1, dans lequel la tabulation d'étalonnage dégénérative 210 est un ensemble de périodes de temps 215 en mois ou en années conformément aux directives de l'industrie, et une valeur d'écart de courant prédite correspondante 217 et une valeur d'écart d'erreur d'angle de phase prédite correspondante 219.

8. Appareil de mesure 400 selon la revendication 1, dans lequel l'adresse d'application 230 du capteur de mesure 100 est un ensemble de détails permanents de niveau un et de niveau deux du capteur de mesure 100.

9. Appareil de mesure 400 selon la revendication 1, dans lequel la connexion électrique est une connexion câblée ou une connexion radio ou une combinaison de celles-ci.

10. Procédé de mesure d'une valeur corrigée d'une ou de plusieurs fonctions primaires par un appareil de mesure 400 comprenant un capteur de mesure 100 et un dispositif de calcul 300, le procédé comprenant les étapes suivantes :
i. Appariement du dispositif de calcul 300 avec le capteur de mesure 100 en configurant une adresse d'application 230 et une ou plusieurs fonctions primaires, et une ou plusieurs fonctions secondaires et une ou plusieurs fonctions dégénératives ;
ii. Recherche et réception par le dispositif de calcul 300 d'une valeur mesurée YMP502 de la fonction primaire ;
iii. Recherche et réception par le dispositif de calcul 300 d'une valeur réelle inférieure suivante et d'une valeur virtuelle correspondante (XLP, YLS) 510, et d'une valeur réelle supérieure suivante et d'une valeur virtuelle supérieure correspondante (XHp, YHP) 520 à partir de la tabulation d'étalonnage primaire 150 ;
iv. Calcul par le dispositif de calcul 300 d'un contour linéaire ou non linéaire d'un segment d'étalonnage 550 ;
v. Calcul par le dispositif de calcul 300 d'une valeur réelle XMp 501 ;
vi. Recherche et réception par le dispositif de calcul 300 d'une valeur mesurée YMS 504 d'une fonction secondaire ;
vii. Recherche et réception par le dispositif de calcul 300 d'une valeur réelle inférieure suivante et d'une valeur virtuelle correspondante (XLs, YLS) 511, et d'une valeur réelle supérieure suivante et d'une valeur virtuelle supérieure correspondante (XHS, YHS) 521 à partir de la tabulation d'étalonnage secondaire 170 ;
viii. Calcul par le dispositif de calcul 300 d'un contour linéaire ou non linéaire d'un segment d'étalonnage 551 ;
ix. Calcul par le dispositif de calcul 300 d'une valeur réelle XMS 503 ;
x. Détermination par le dispositif de calcul 300 d'une fonction dégénérative en référence à un vieillissement en temps réel ;
xi. Sélection par le dispositif informatique 300 d'une valeur d'écart prédite de la fonction primaire ;
xii. Calcul par le dispositif de calcul 300 d'une valeur corrigée de la fonction primaire en prenant en calcul toutes les valeurs réelles de la fonction primaire, de la fonction secondaire et de la fonction dégénérative.

11. Procédé selon la revendication 10, dans lequel le dispositif de calcul 300 considère une valeur par défaut lors de la recherche et de la non-réception d'une valeur virtuelle 420.

12. Procédé selon la revendication 10, dans lequel le capteur de mesure 100 est n'importe quel capteur de mesure 100 avec une adresse d'application compatible 230.
